# EUROPEAN PATENT SPECIFICATION

(11) **EP 0 676 800 B1**
(45) Date of publication and mention of the grant of the patent: **18.12.2002**
(21) Application number: 95105372.7
(22) Date of filing: 10.04.1995
(51) Int. Cl.: H01L 21/48, H01L 23/373, C04B 41/88, B22D 19/14, C23C 2/00

(54) **Process for producing a metal-bonded-ceramic material or component and its use as an electronic circuit substrate**
Prozess zur Herstellung von metallbondiertem Keramikmaterial oder Komponente und dessen Verwendung als Substrat für eine elektronische Schaltung
Procédé de fabrication de matériau ou de composant avec une liaison métal-céramique et son utilisation pour un substrat de circuit électronique

(30) Priority: 11.04.1994 JP 9694194
(43) Date of publication of application: 11.10.1995
(60) Divisional application: 02012565.4
(73) Proprietor: Dowa Mining Co., Ltd., Chiyoda-ku, Tokyo (JP)
(72) Inventor: Ning, Xiao-Shan, c/o Dowa Mining Co., Ltd., Tokyo (JP); Nagata, Choju, c/o Dowa Mining Co., Ltd., Tokyo (JP); Sakuraba, Masami, c/o Dowa Mining Co., Ltd., Tokyo (JP); Tanaka, Toshikazu, c/o Dowa Mining Co., Ltd., Tokyo (JP); Kimura, Masami, c/o Dowa Mining Co., Ltd., Tokyo (JP)
(74) Representative: Strehl Schübel-Hopf & Partner

(56) References cited:
- EP-A- 0 252 519
- EP-A- 0 351 203
- FR-A- 2 109 254
- US-A- 3 994 430
- CHEMICAL ABSTRACTS, vol. 117, no. 6, 10 August 1992 Columbus, Ohio, US; abstract no. 54498w, H. MIYAZAKI: page 371; XP000374964 & JP-A-00 475 758 (ID.)
- CHEMICAL ABSTRACTS, vol. 111, no. 6, 7 August 1989 Columbus, Ohio, US; abstract no. 44255b, I. OKAMOTO: page 312; XP000059374 & JP-A-00 109 884 (ID.)
- PATENT ABSTRACTS OF JAPAN vol. 013, no. 062 (E-715) 13 February 1989 & JP 63 250 022 A (SUMITOMO ELECTRIC IND LTD) 17 October 1988

## Description

### BACKGROUND OF THE INVENTION

This invention relates to a process for producing metal-bonded-ceramic (MBC) material or components, particularly to an industrial process for producing MBC material or components of aluminum with ceramics that are suitable for use in automotive parts, and electronic parts. The invention also relates to the use of MBC plates produced by that process as electronic circuit substrates.

MBC components are extensively used in automobiles, electronic equipment and other applications by taking advantages of the chemical stability, high melting points, insulating property and high hardness of ceramics in combination with the high strength, high toughness, free workability and conducting property of metals. Typical applications of the components include as substrates and packages for mounting large-power electronic elements.

MBC material and components are known to be produced by various methods including adhesion, plating, metallizing, thermal spraying, brazing, DBC, shrink fitting and casting. Adhesion is a process in which a metal member is joined to a ceramic member with an organic or inorganic adhesive. Plating is a process that comprises activating the surface of a ceramic member and dipping it in a plating bath to apply a metal plate. Metallizing is a process that comprises applying a paste containing metal particles to the surface of a ceramic member and sintering it to form metal layer. Thermal spraying is a process in which molten metal (or ceramic) drops are sprayed onto the surface of a ceramic (or metal) member so that a metal (or ceramic) layer is formed on that surface. Brazing is a process in which metal and a ceramic member are joined with the aid of a low-melting point filler metal or alloy. To insure that the filler metal or alloy is securely joined to the ceramic member, a metal component highly reactive with ceramics is added or metal layer is preliminarily formed on the joining surface of the ceramic member by a suitable method such as metallizing or thermal spraying. DBC is a technique specially developed for the purpose of bonding an oxide ceramic member to a copper member. According to DBC, an oxygen containing copper member is heated in an inert atmosphere while it is joined to the ceramic member or, alternatively, the surface of an oxygen-free copper plate is first oxidized to form an oxide layer and then it is joined to the ceramic member. To join a nonoxide ceramic member to the copper member by DBC, an oxide layer must be formed preliminarily on the surface of the nonoxide ceramic member. In shrink fitting, the ceramic and metal members to be joined are provided with a projection and a cavity, respectively, in such a way that the outside diameter of the projection is equal to the inside diameter of the cavity and the metal member is heated to expand the cavity, into which the projection of the ceramic member is inserted; thereafter, the two members are cooled so that they form an integral assembly in which the projection on the ceramic member is nested in the cavity in the metal member. Casting is similar to shrink fitting, except that a metal is cast around a ceramic member and cooled so that it shrinks to have the ceramic member nested as an integral part.

These prior art methods, however, have their own problems. Adhesion produces composites that are low in adhesion strength and heat resistance. The applicability of plating, metallizing and thermal spraying is usually limited to the case of forming thin metal (or ceramic) layers whose thickness ranges from a few microns to several tens of microns. Shrink fitting and casting are only applicable to a special case in which at least part of a ceramic member is to be nested in a metal. In DBC, copper is the only metal that can be joined and the temperature for jointing must be within a narrow range close to the eutectic point of Cu-O and, hence, there is high likelihood for the development of joining defects such as swelling and incomplete joining. Brazing uses expensive filler metals or alloys and requires the joining operation to be performed in vacuum and, hence, the operational cost is high enough to prevent the use of the method in a broad range of applications.

As already mentioned, MBC components can be used as substrates for mounting large-power electronic elements. Currently used MBC substrates comprise ceramic substrates having copper circuit patterns formed on the surface. Depending on the kind of the ceramic substrate used and the process for producing the MBC substrates, commercial composite substrates are classified as copper/alumina directly joined substrates, copper/aluminum nitride directly joined substrates, copper/alumina brazed substrates and copper/aluminum nitride brazed substrates.

A method for producing copper/alumina directly joined substrates is described in Unexamined Published Japanese Patent Application (kokai) Sho-52-37914; an oxygen-containing copper plate is superposed on an alumina substrate or, alternatively, an oxygen-free copper plate is heated in an oxidizing atmosphere to generate copper oxide on the surface of the oxygen-free copper plate before the copper plate is joined to the alumina substrate with a composite oxide of copper and aluminum being formed at the interface.

To produce copper/aluminum nitride directly joined substrates, an oxide must first be formed on the surface of an aluminum nitride substrate. A method of production is described in Unexamined Published Japanese Patent Application (kokai) Hei 3-93687; the aluminum nitride substrate is first treated in air at a temperature of about 1,000°C to form an oxide layer on the surface and, then, a copper plate is joined to the aluminum nitride substrate with the intermediary of the oxide layer by the method described in the preceding paragraph.

To produce copper/alumina or aluminum nitride brazed substrates, a copper plate is joined to a ceramic substrate with the aid of a low-melting point filler metal. A commonly used filler metal is made from an alloy comprising Ag, Cu and Ti. In this case the purpose of adding Ag is to lower the melting point and that of adding Ti is to enhance the wetting capability of the filler metal to ceramics.

In spite of their common use, copper/ceramic composite substrates have several problems that are encountered during fabrication and actual use. The most serious problem is that cracks will develop in the ceramic substrate during the mounting of electronic element and use of thus assembled electronic device. This defect is attributable to the thermal expansion coefficient of copper which is higher than that of ceramics by about one order of magnitude. During the jointing operation, both the ceramic substrate and copper are heated to about 1,000°C and as they are cooled from the joining temperature to room temperature, considerable thermal stress will develop within the MBC substrate due to the thermal expansion difference. When mounting electronic elements on MBC substrates, the latter are heated to about 400°C and also the temperature of the MBC substrate will change all the time due to the temperature change in the operating environment or due to the generation of heat during the use of the assembled electronic devices, whereby the MBC substrates are subjected to varying thermal stresses. On account of these thermal stresses, cracks will develop in the ceramic substrate.

An important factor to the evaluation of the MBC substrates is resistance to heat cycles. This factor is expressed by the number of times a substrate can be subjected to repeated heating and cooling cycles between -40°C and 125°C without developing cracks due to thermal stresses. The copper-bonded-ceramic substrates can only withstand several tens heat cycles under the indicated conditions. What is more, in order to acquire resistance to the heat cycles, the thickness of the ceramic substrate has to be greater than the sum of the thicknesses of copper plates joined to both principal surfaces of the ceramic substrate. This means that the thickness of the ceramic substrate must be increased beyond the value necessary to maintain its inherent electrical insulating property. As a result, heat conduction which is another important characteristic of the MBC substrates is sacrificed.

In recent years, the development of power modules for installation on electric cars has increased a particular demand for MBC substrates having improved resistance to heat cycles. Under severe use conditions as in electric cars where temperatures changes are violent and great vibrations occur, resistance to 3,000 heat cycles and more is said to be necessary. However, this requirement cannot be met by the copper-bonded-ceramic substrates in current use.

Aluminum is as good an electric and heat conductor as copper and the idea of using it as a conductive circuit material is easy to be conceived, as typicaly described in Unexamined Published Japanese Patent Application (kokai) Sho 59-121890. Generally brazing is used to join aluminum and ceramics and Unexamined Published Japanese Patent Applications (kokai) Hei 3-125463, Hei 4-12554 and Hei 4-18746 teach aluminum-ceramic substrates produced by brazing. These substrates can withstand about 200 heat cycles but they are still unsuitable for use in electric cars and in other applications where very high resistance to heat cycles is required. As a further problem, brazing must be conducted in vacuum and nonoxide ceramics must be subjected to a preliminary treatment for forming an oxide on the surface and this makes the brazing process unsatisfactory in terms of not only production cost but also heat conduction.

Thus, the prior techniques for joining metal and ceramic members have had one or more of the problems listed below:
1) the metal and ceramic members to be joined are limited to those having certain shapes;
2) the joining step is costly and limited in the scope of applications; and
3) the joined members do not meet the performance requirements for joint strength, heat resistance and resistance to heat cycles.

An example of the prior techniques is provided in US-A-3994430. This document discloses a method of bonding metals, and as Al or Cu to a ceramic substrate by providing an eutectic alloy of the respective metal as a bonding agent and heating to the melting temperature of the eutectic, but below the melting temperature of the metal.

EP 0252519 A1 discloses an aluminum nitride circuit substrate comprising an aluminum nitride plate and a conductive material bonded to the aluminum nitride plate through a metallized layer. The stated metallized layer comprises (1) at least one of the elements Mo, W and Ta and (2) at least one element selected from elements of groups IIa, IIIa, IIIb, IVa of the periodic system and rare-earth elements, and actinoide elements. The metallized layer may be formed by a conventional method employing a binding agent.

JP-A-63-250022 relates to a process for producing a superconductive conductor, in which a ceramic super conductor is stabilised by coating its entire surface with a metal. The coating is achieved by introducing the superconductor into a molten metal and making it to pass through the melt. In this way the superconductive ceramic part is fully enclosed by a metal sheat which is bonded by shrink fitting.

### SUMMARY OF THE INVENTION

The present invention has been accomplished to solve these problems of the prior art and has as an object providing a process by which MBC material or components having improved characteristics can be manufactured at low cost.

Another object of the invention is to provide MBC plates produced by that process.

A further object of the invention is to provide MBC electronic circuit substrates that are fabricated from said MBC plates.

The present inventors conducted intensive studies with a view to attaining these objects and found an effective method of bonding molten aluminum to ceramics, as well as an effective method of shaping metals. The present invention has been accomplished on the basis of these findings.

In its first aspect, the present invention provides a process for producing MBC material or MBC components 5 having a metal joined to a part of ceramic members 2, while another part thereof is left free, which is defined in claim 1.

Specific embodiments of this invention are as defined in the subclaims.

The invention is further directed to the use of an aluminnum-bonded ceramic obtained by the process according to claim 1 as an insulating circuit substrate.

A predetemined circuit pattern is formed by etching the metal plate of the MBC plate member described above.

### BRIEF DESCRIPTION OF THE DRAWINGS

Fig. 1 is a schematic section of the apparatus used in Examples 1 - 6 to form MBC material or components;
Fig. 2 is a diagram snowing the basic concept of the invention;
Fig. 3 is a sectional view showing the cross section of the die used in Example 1 to manufacture MBC material;
Fig. 4 is a sectional view showing the cross section of the die used in Example 2 to manufacture MBC material;
Fig. 5 is a sectional view showing the cross section of the die used in Example 3 to manufacture MBC material;

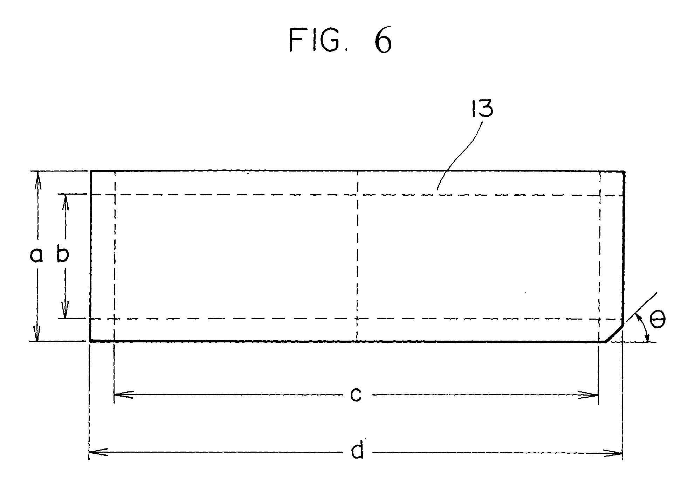

Fig. 6 is diagram showing the dimensions of the ceramic substrates used in Examples 5 and 6, as well as the positisions of the breaking lines, wherein a=36mm, b=26mm, c=102mm, d=112cm, θ=45° ; and
Fig. 7 is a diagram showing the circuit patterns formed on one side and the base metal on the other side of the aluminum-bonded-ceramic substrate by etching method.

### DETAILED DESCRIPTION OF THE INVENTION

Metals are joined to ceramics in one of three modes, mechanical, physical and chemical, which are designated according to the joining mechanism involved. Mechanical joining is achieved when a projection on a ceramic member is nested in a cavity in a metal member by a mechanical force as in the case of joining the two members by shrink fitting or casting; mechanical joining is also achieved if, as in the case of adhesion, an adhesive gets into recesses in the surfaces of the ceramic and metal members to exhibit an "anchor" effect when cured, thus producing an integral assembly of the metal and ceramic members. Physical joining is achieved by the force of attraction (van der Waals forces) acting between the molecules of a ceramic member and metal atoms. Chemical joining is achieved by covalent bonding (sharing) or ionic bonding (transfer) between electrons within a ceramic molecule and those in a metal atom. Since chemical bonding is established if electronic sharing or transfer occurs between surface molecules (electrons) of a ceramic and a metal member, reaction products that can be discovered by physical means (e.g. common optical microscope, SEMs and TEMs) will not necessarily exist at the interface between the ceramic and metal members. In this case, it is often difficult to distinguish physical joining from chemical joining solely in view of the state of the interface. As a matter of fact, there are many cases where several joining mechanisms occur simultaneously at the interface between the members to be joined but in order to achieve reliable joining, it is essential that either phycical or chemical joining be accomplished.

Whether the joining that occurs is physical or chemical is frequently determined by the state of wetting. Generally speaking, the drop of a liquid placed on a solid will spread until it reaches an equilibrium after the lapse of a certain time. Suppose the line of contact among the three phases of a liquid-solid-gas (atmosphere) system at equilibrium.

Draw a tangent to the liquid at its contact with the solid and the angle of contact is the angle between the tangent and the surface of the solid, as measured on the side the liquid drop is present. The thus measured angle of contact is an indication of the state of wetting of the solid by the liquid. When physical or chemical joining occurs, the angle of contact generally decreases. In the present invention, the state of wetting is investigated by the following simpler and more practical procedure. That is, the ceramic member 2 is brought into contact with the metal melt 1 which has been heated at a given temperature; after the lapse of a certain time, the ceramic member 2 is taken out of the melt 1; the metal that adheres loosely to the cooled surface of the ceramic member 2 is scraped off and the state of wetting of the ceramic member 2 by the metal is investigated.

The first step of achieving physical or chemical joining is cleaning the surfaces of the members to be joined. It is well known to those skilled in the art that no strong joints can be realized unless the joining operation is preceded by degreasing in order to remove oil from the surfaces of the members to be joined.

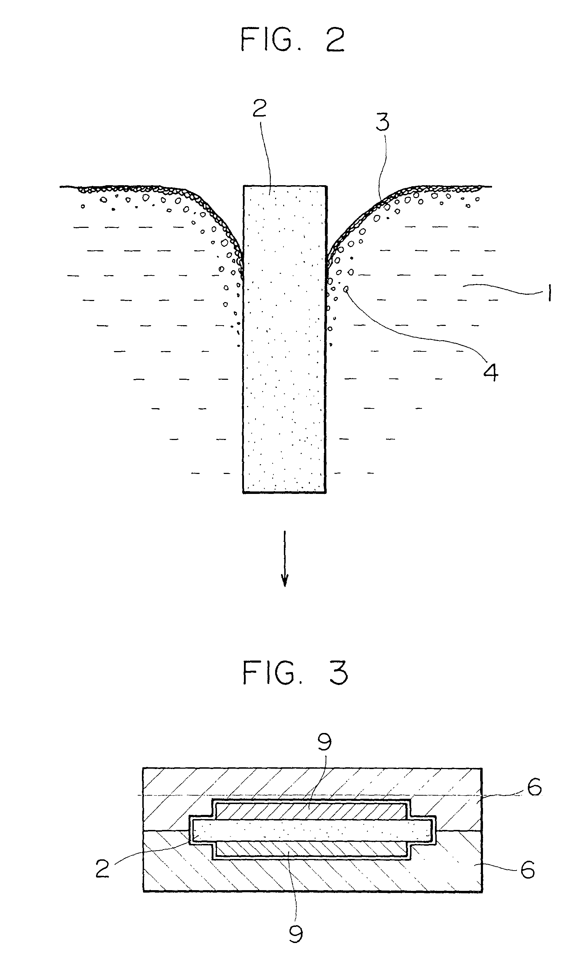

Fig. 2 is a diagram showing the basic concept of the invention. If the ceramic member 2 is to be moved through the metal melt only a small distance. It is insufficient to assure complete removal of the deleterious ingredient 4 on the surface of the ceramic member and the deleterious ingredient 3 on the surface of the metal melt; as a result, part of the ceramic member 2 remains unwetted by the metal 1, making it impossible to accomplish secure joining between the ceramic member and the metal. In order to avoid this incomplete joining, the distance over which the ceramic member 2 is moved through the metal melt 1 must exceed a certain minimum value (Dmin). This minimum value is variable with many factors such as the characterisitcs of the metal 1 and the ceramic member 2, as well as the status of any deleterious ingredients on their surfaces, the temperature, the atmosphere and the rate of movement of the ceramic member 2. In the examples of the invention to be described hereinafter, the minimum distance (Dmin) ranges from a few millimeters to several tens of millimeters.

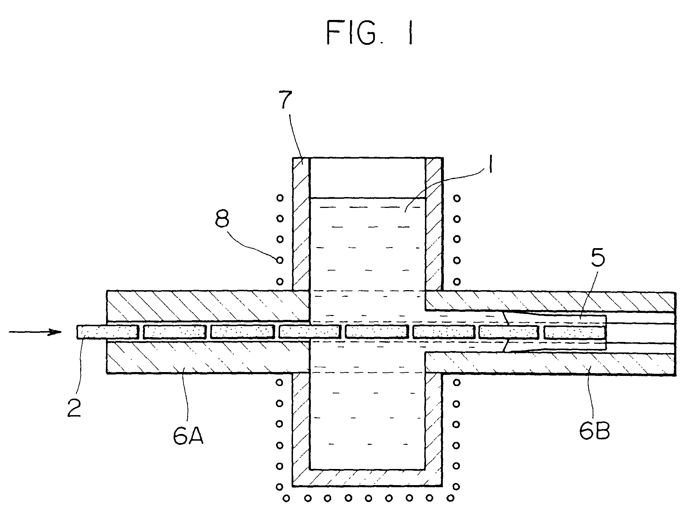

In Example 1 to be described hereinafter, there is disclosed an exemplary process for producing the MBC material 5. Fig. 1 is a schematic section of the apparatus for implementing the process and Fig. 3 is a sectional view showing the cross section of the die 6. The ceramic member 2 is fed successively into the molten metal 1 through the guide 6A linked to the die 6B and, after being thoroughly wetted by the melt, exits from the die 6B to form a metal part of a predetermined shape in a predetemined area of the ceramic member 2. The resulting MBC material 5 is structurally integral if the dimension of the melt in the moving direction of the ceramic member 2 is set to be longer than the minimum distance required for the ceramic member 2 to be wetted by the melt.

The example just described above is strictly intended to illustrate the essence of the invention. In all the examples to be described hereinafter, the ceramic member 2 is made of alumina, but it should also be understood in the light of the above-described spirit of the invention that it is by no means limited to alumina. Combinations of aluminum and other ceramics may equally be applicable as long as the ceramic member 2 can be wetted by the molten aluminum 1.

Needless to say, the temperature, the atmosphere and the rate of movement of the ceramic member 2 are very important parameters for the purposes of the present invention. However, different ceramic members 2 have different characteristics and, hence, these parameters are variable with what members are to be joined. These conditions should be selected in such a way that the ceramic member 2 will be effectively wetted by the molten metal 1. The proper selection of these conditions is an important step for assuring that the advantages of the invention will be exhibited to the fullest extent. When selecting these conditions one must take the following point into account: in the process of the invention, effective wetting is essential for producing the MBC material or components 5 and raising the temperature of the melt or extending the contact time is certainly effective for the purpose of improving the wetting; however, if the temperature of the melt or the contact time is increased unduly, the metal member and the ceramic member 2 will react to form a thick reaction product at their interface, which can potentially lower the strength of joint between the two members.

By using the process of the invention, the present inventors could produce MBC plate members and they could also fabricate MBC electronic circuit substrates. Before forming metal circuit patterns by etching, the MBC plate members produced by the process of the invention has to be separated by shearing at the connecting portions of the ceramic substrates and it is also necessary to form resist patterns on a polished surface of the metal portion. Resist patterns can be formed by various method; in one method, a light-sensitive resist film is compressed onto the surface of the metal portion, exposed to light through an overlying pattern mask, and developed to remove the resist in the unwanted areas; alternatively, a layer of liquid resist is printed in a predetermined pattern directly onto the metal and exposed to UV light to cure the resist. After these pretreatments, an etching solution is sprayed onto the composite substrate having the resist patterns formed thereon and the metal is removed from the resist-free areas to form metal circuit patterns of the predetermined shapes.

In the examples to be described hereinafter, alumina and aluminum nitride substrates were used as ceramic substrates but it is contemplated that other ceramic substrates made of silicon carbide, zirconia, etc., as well as various glass substrates are also applicable with equally good results. As for the metal to be composited with the ceramic member, pure aluminum metal was used since it was a good electric conductor that would also insure softness. The purity of the aluminum used was 99.9% (3N) in order to achieve a balance between the electric conductivity (which increases with the purity) and the price. However, it should of course be understood that this is not the sole case of the present invention.

The following examples are provided for the purpose of further illustrating, with reference to the accompanying drawings, the process of the invention and the electronic circuit substrate that can be fabricated by the process.

### Example 1

The experimental setup shown in Fig. 1 was used; the die 6B on the exit side had the cross section shown in Fig. 3. Aluminum was set in a crucible 7. Alumina plates were fed from the inlet into the guide 6A and it was set in such a way that its forward end would protrude a little from the inner surface of the crucible 7. The crucible 7 was heated in a nitrogen (N₂) gas atmosphere to melt the aluminum. The molten aluminum entered the die 6B on the exit side and as it flowed through the die, the temperature of its advancing end dropped below the melting point of aluminum and solidified to clog the exit of the die, thereby preventing the melt from flowing out. In order to ensure that the melt would not get into the guide 6A on the entrance side or into the space between the die and the crucible 7, the clearance has to be smaller than a certain value; in Example 1, the clearance was set to be smaller than 0.1 mm. After the molten aluminum was heated to a preset temperature, the alumina plates were fed successively into the guide 6A on the entrance side. The alumina plates entered the molten aluminum successively, were wetted by the melt, entered the die 6B on the exit side, and were finally extruded from the exit successively, with an aluminum part 0.5 mm thick joining to both surfaces of each alumina plate. In Example 1, the minimum distance Dmin over which each alumina plate moved until it was wetted by aluminum melt was measured with the heating temperature, extruding temperature and the flow rate of nitrogen gas being set at various values. Samples were sliced from the thus prepared aluminum-bonded-alumina plates and evaluated by the method described in Reference 1, supra (Japanese Patent Application Hei 4-355211). For Dmin measurement, the crucible 7 was emptied of the melt and the alumina plate was recovered and the distance between the point where it started to contact the aluminum melt and the area that was completely wetted by the melt was measured. The results are shown in Table 1 for the samples prepared. All samples except Lot E were characterized by a dense aluminum structure and had peel strengths in excess of 35 kg/cm. Thus, aluminum-bonded-alumina plates of satisfactory quality could be produced by the process of the invention.

**Table 1**

| Lot | Melt temperature, °C | Extrusion Speed, mm/min | N₂ flow rate, L/min | Dmin, mm | Aluminum structure | Peel strength kg/cm |
|---|---|---|---|---|---|---|
| A | 700 | 25 | 30 | 55 | good | >35 |
| B | 800 | 25 | 30 | 35 | good | >35 |
| C | 850 | 25 | 30 | 14 | good | >35 |
| D | 900 | 25 | 30 | 9 | good | >35 |
| E | 900 | 50 | 30 | 23 | with cavities | - |
| F | 900 | 25 | 10 | 87 | good | >35 |

### Example 2

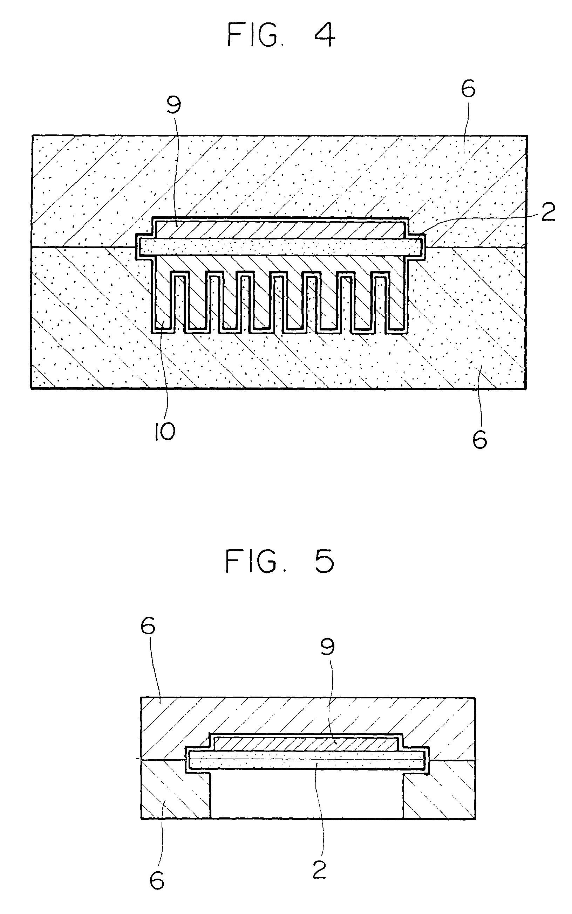

Aluminum-bonded-alumina plates having heat-dissipating fins 10 (see Fig. 4) on one side were produced by repeating the procedure of Example 1 except for the following points: the die 6B on the exit side had an interior as shown in cross section in Fig. 4; the melt temperature, extrusion speed and the flow rate of nitrogen gas were set at 850°C, 25 mm/min and 30L/min, respectively; a pressure of 0.5 kg/cm² was applied to the melt to accelerate its run and to prevent the formation of cavities. The MBC material thus produced had satisfactory quality.

### Example 3

MBC material having copper plates on one side and aluminum heat-dissipating fins 10 on the other side were produced by repeating the procedure of Example 2 except for the following points: the alumina plates had a copper plate joined to one surface by DBC; the guide in the melt was worked to have the cross-sectional shape shown in Fig. 5. The MBC material thus produced had satisfactory quality.

### Example 4

MBC components having aluminum fins joined to the circumference of ceramic pipes were produced by repeating the procedure of Example 2 except for the following points: a plurality of alumina pipes each having an outside diameter of 50 mm, a wall thickness of 5 mm and a length of 500 mm were provided as ceramic members; the die profile was changed from a rectangular to a circular shape.

### Example 5

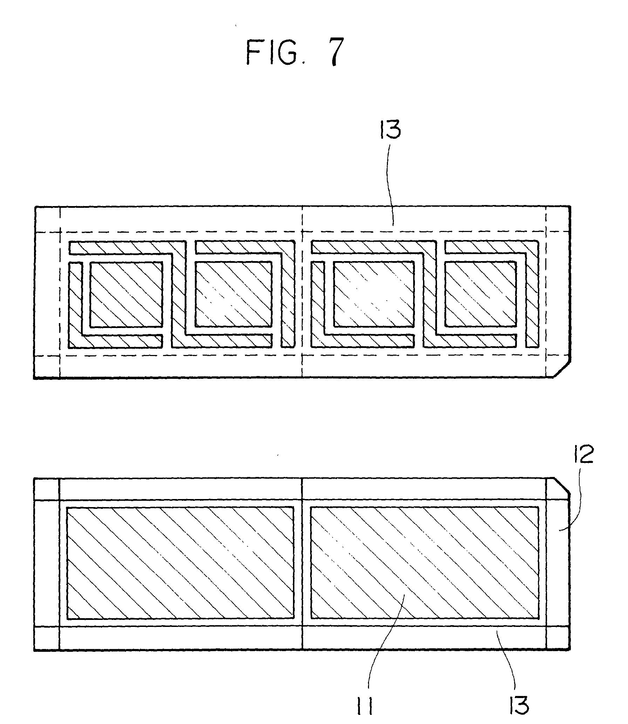

Aluminum-bonded-alumina plates were produced by repeating the procedure of Example 1 except that a plurality of alumina substrates 0.635 mm thick having breaking lines as shown in Fig. 7 were provided as ceramic substrates. Each MBC member was broken apart in the connecting portions and the surface of the metal portion was polished in preparation for resist formation.

After resist formation the metal portion of each MBC substrate was sprayed with a liquid etchant in the form of an aqueous solution of a mixture of 35% 40 Be iron chloride and 10% HCl, whereby circuit patterns of the geometries shown in Fig. 8 were formed on opposite sides of MBC substrate. The surfaces of the circuit patterns were subjected to a treatment for zinc replacement and a nickel plate was deposited in a thickness of 3 - 5 µm. The thus fabricated composite substrate was split along the breaking lines to yield two aluminum-bonded-alumina electronic circuit substrates each having a width of 26 mm and a length of 51 mm.

The MBC substrates were found to have the following characteristics:
Peel strength > 30 kg/cm (aluminum broke)
Resistance to heat cycles > 3,000 cycles (without cracking)
Bending strength = 69 kg/mm²
Deflection = 286 µm

### Example 6

Aluminum-bonded-aluminum nitride directly joined substrates were produced by repeating the procedure of Example 6 except that the alumina substrates were replaced by aluminum nitride plates measuring 36 mm x 52 mm x 0.635 mm. The MBC substrates thus produced had the following characteristics:
Peel strength > 20 kg/cm
Resistance to heat cycles > 3,000 cycles
Bending strength = 53 kg/mm²
Deflection = 230 µm

According to the process of the present invention, one can produce satisfactory MBC material or components 5 of many various shapes at low cost. The invention also provides MBC electronic circuit substrates having satisfactory characteristics.

## Claims

1. A process for producing a metal-bonded ceramic (MBC) material or MBC components (5) having a metal jointed to a part of a ceramic member (2) while another part thereof is left uncovered, wherein said metal is aluminum and said process comprises bringing the part of the ceramic member (2) to be joined to the aluminum in contact with a melt (1) of the aluminum in a nitrogen gas atmosphere, moving said ceramic member (2) through the melt (1) over a distance that exceeds a certain minimum value (D min) in the range of a few millimeters to several tens of millimeters which is the minimum distance required to cause the surface of the ceramic member (2) to be fully wetted by the aluminum melt (1) and thereafter cooling to solidify the melt on the surface of said ceramic member (2) to obtain the MBC material or components (5) having a predetermined shape of the aluminum part.

2. A process for producing MBC material or components (5) according to claim 1 wherein the shape of said ceramic member (2) is a plate.

3. A process for producing MBC material or component (5) according to any of claims 1 or 2 wherein the shape of the aluminum joined to the ceramic member (2) is a plate.

4. The process for producing MBC material or components (5) according any one of claims 1 to 3 wherein said ceramic member (2) is made of an oxide.

5. The process for producing MBC material or component (5) according any one of claims 1 to 3 wherein said ceramic member (2) is made of a nitride.

6. The process according to any of the claims 1 to 3, wherein the ceramic member (2) is made of alumina or aluminium nitride.

7. The use of an aluminum-bonded ceramic comprising a ceramic plate having directly bonded thereon an aluminum member obtainable by the process of claim 1 as an insulating circuit sutstrate.

8. The use according to claim 7, wherein said ceramic plate is an alumina plate.

9. The use according to claim 7, wherein said ceramic plate is an aluminum nitride plate.

## Patentansprüche

1. Verfahren zur Herstellung eines Metall-Keramik-Verbundmaterials (MBC-Material) oder von MBC-Komponenten (5), in denen ein Metall an einem Teil eines Keramikelements (2) gebunden ist, während ein anderer Teil davon unbedeckt bleibt, wobei das Metall Aluminium ist und das Verfahren das Kontaktieren des mit dem Aluminium zu verbindenden Teils des Keramikelements mit einer Schmelze (1) des Aluminiums in einer Stickstoffgas-Atmosphäre, des Bewegens des Keramikelements (2) durch die Schmelze (1) über eine Distanz, die einen bestimmten Minimalwert (D min) im Bereich von einigen Millimetern bis zu mehrerer 10 mm hat, welche die Mindestdistanz ist, die zum vollständigen Benetzen der Oberfläche des Keramikanteils (2) mit der Aluminiumschmelze (1) erforderlich ist, und darauf folgendes Kühlen zur Verfestigung der Schmelze auf der Oberfläche des Keramikelements (2) umfaßt, wobei das MBC-Material oder die MBC-Komponenten (5) mit einer vorbestimmten Gestalt des Aluminiumteils erhalten werden.

2. Verfahren zur Herstellung eines MBC-Materials oder von MBC-Komponenten (5) nach Anspruch 1, wobei die Gestalt des Keramikelements (2) die einer Platte ist.

3. Verfahren zur Herstellung eines MBC-Materials oder einer MBC-Komponente (5) nach einem der Ansprüche 1 oder 2, wobei die Gestalt des mit dem Keramikelement (2) verbundenen Aluminiums die einer Platte ist.

4. Verfahren zur Herstellung eines MBC-Materials oder von MBC-Komponenten (5) nach einem der Ansprüche 1 bis 3, wobei das Keramikelement (2) aus einem Oxid besteht.

5. Verfahren zur Herstellung eines MBC-Materials oder einer MBC-Komponente (5) nach einem der Ansprüche 1 bis 3, wobei das Keramikelement (2) aus einem Nitrid besteht.

6. Verfahren nach einem der Ansprüche 1 bis 3, wobei das Keramikelement (2) aus Aluminiumoxid oder Aluminiumnitrid besteht.

7. Verwendung eines Aluminium-Keramik-Verbundmaterials, das eine Keramikplatte umfaßt, an die ein Aluminiumteil direkt gebunden ist, das durch das Verfahren des Anspruchs 1 erhältlich ist, als isolierendes Schaltkreis-Substrat.

8. Verwendung nach Anspruch 7, wobei die Keramikplatte eine Aluminiumoxid-Platte ist.

9. Verwendung nach Anspruch 7, wobei die Keramikplatte eine Aluminiumnitrid-Platte ist.

## Revendications

1. Procédé pour produire un matériau à base de céramique collée à un métal (MBC) ou des composants à base de MBC (5) ayant un métal lié à une partie d'un élément en céramique (2) alors qu'une autre partie de celui-ci est laissée libre, dans lequel ledit métal est l'aluminium et ledit procédé comprend d'amener la partie de l'élément en céramique (2) qu'on doit lier à l'aluminium au contact avec une masse fondue (1) de l'aluminium sous une atmosphère d'azote gazeux, de déplacer ledit élément en céramique (2) à travers la masse fondue (1) sur une distance qui dépasse une certaine valeur minimale (D min) dans l'intervalle allant de quelques millimètres à plusieurs dizaines de millimètres qui est la distance minimale requise pour que la surface de l'élément en céramique (2) soit complètement mouillée par la masse fondue d'aluminium (1) et après cela de refroidir pour solidifier la masse fondue sur la surface dudit élément en céramique (2) pour obtenir le matériau ou les composants à base de MBC (5) ayant une forme prédéterminée de la partie en aluminium.

2. Procédé pour produire un matériau ou des composants à base de MBC (5) selon la revendication 1 dans lequel la forme dudit élément en céramique (2) est celle d'une plaque.

3. Procédé pour produire un matériau ou un composant à base de MBC (5) selon l'une quelconque des revendications 1 ou 2 dans lequel la forme de l'aluminium lié à l'élément en céramique (2) est celle d'une plaque.

4. Procédé pour produire un matériau ou des composants à base de MBC (5) selon l'une quelconque des revendications 1 à 3 dans lequel ledit élément en céramique (2) est composé d'un oxyde.

5. Procédé pour produire un matériau ou un composant à base de MBC (5) selon l'une quelconque des revendications 1 à 3 dans lequel ledit élément en céramique (2) est composé d'un nitrure.

6. Procédé selon l'une quelconque des revendications 1 à 3, dans lequel l'élément en céramique (2) est composé d'alumine ou de nitrure d'aluminium.

7. Utilisation d'une céramique collée à de l'aluminium comprenant une plaque en céramique ayant un élément en aluminium directement collé sur celle-ci qu'on peut obtenir par le procédé de la revendication 1 comme substrat de circuit isolant.

8. Utilisation selon la revendication 7, dans laquelle ladite plaque en céramique est une plaque en alumine.

9. Utilisation selon la revendication 7, dans laquelle ladite plaque en céramique est une plaque en nitrure d'aluminium.
